Europäisches Patentamt

European Patent Office

Office européen des brevets

(19)

(11) Publication number: **0 142 025**
**B1**

(12) **EUROPEAN PATENT SPECIFICATION**

(45) Date of publication of patent specification: **03.01.90**

(51) Int. Cl.⁵: **C 23 C 18/28**

(21) Application number: **84112111.4**

(22) Date of filing: **10.10.84**

(54) **Improved method for depositing a metal on a surface.**

(30) Priority: **12.10.83 US 541048**

(43) Date of publication of application:
**22.05.85 Bulletin 85/21**

(45) Publication of the grant of the patent:
**03.01.90 Bulletin 90/01**

(84) Designated Contracting States:
**CH DE FR GB IT LI**

(56) References cited:
**US-A-3 930 963**
**US-A-4 084 023**
**US-A-4 133 908**
**US-A-4 268 536**
**US-A-4 304 849**

**PLAT. SURF. FINISH, vol. 64, no. 11, 1977,
columns 1-6; B. F. ROTHSCHILD et al.: "Carbon
treatment of pyrophosphate copper baths for
improved printed wiring board production"**

(73) Proprietor: **KOLLMORGEN TECHNOLOGIES
CORPORATION
66 Gatehouse Road
Stamford Connecticut 06902 (US)**

(72) Inventor: **Teng, Yu-Ling
240-08 65th Street
Douglaston, NY 11362 (US)**
Inventor: **Mayernik, Richard
1320 Jerusalem Avenue
North Merrick, NY 11566 (US)**

(74) Representative: **Königseder, geb. Egerer,
Claudia
Zugspitzstrasse 65
D-8104 Grainau (DE)**

Courier Press, Leamington Spa, England.

# EP 0 142 025 B1

**Description**

The present invention relates to a method of depositing metal on a surface and, more particularly, to an improved method for the production of circuit boards with good line definition and clean non-conductor area as well as for extending the bath life of fixing solutions employed in the manufacture of fixing solutions employed in the manufacture of printed circuit boards involving a photosensitive electroless deposition process.

The photosensitive processes as, described in US patents 3,772,056, 3,722,078, 3,907,611, 3,930,963, 3,925,578, 3,959,547, 3,993,802 and 3,994,727 use water as the image developing media.

The image was formed by a light sensitive mixture of a copper salt, anthraquinone disulfonic acid and a polyhydroxyl alcohol, such as glycerine, pentaerythritol or sorbitol. The mixture was applied from aqueous solution to a hydrophilic surface and subsequently dried under controlled conditions before light exposure. In the water development following light exposure, the unexposed copper salts and anthraquinone disulfonic acid were rinsed away. The next step was reinforcement of the image formed by electroless plating to produce a copper conductor pattern.

In production, the process was plagued by copper deposits outside the conductor pattern. Increasing the water rinse or development either with longer time or more vigorous agitation resulted in a weakening of the image, characterized by breaks and voids in the conductor pattern. As an alternative to excessive rinsing or development, a number of intermediate process steps have been proposed for insertion between the water rinse or development and the electroless plating. The purpose of these steps is to fix the image before it is electrolessly plated.

In US patent 4,262,085 it has been proposed that the light image be intensified by immersion in a palladium sulfate solution followed by a nickel flash plating. The inventor of '085 alleged that the undesired copper on the background from incomplete development would be removed and would not be a catalyst for electroless nickel. The nickel conductor can then be electrolessly copper plated to the required thickness without extraneous deposits.

In US patent 4,084,023 it has been proposed a fixing solution consisting of an alkaline EDTA copper complexing solution and formaldehyde, a reducing agent for copper.

The purpose of this solution was to dissolve any incompletely developed copper from the background of the panel and, at the same time, prevent destruction of copper sites formed on the light image. This fixer solution was not completely successful.

US patent 4,181,750 discloses acid stripping solutions consisting of dilute citric or acetic acid solutions.

In US patent 4,133,908 it is reported that the stripping and/or fixing solutions disclosed in US 4,181,750 and 4,084,023 were not effective and an image stabilizer potassium ferrocyanide addition to the fixing solution of 4,084,023 is proposed.

In US patent 4,167,601 the process of first fixing in the stabilizer solution according to US 4,133,908 followed by stripping solution according to US 4,181,908 is described.

Until now, the lifespan of fixing solutions employed in the above described methods has been relatively short. Moreover, they were uncontrollable with respect to activity and adversely became colored after short periods of loading. As a result, workers in the field had to constantly replenish the fixing solutions, a measure which is time-consuming and costly.

It was believed that the aforedescribed shortcoming of fixing solutions was attributable to the build-up of certain contaminants after a short period of use. Simply replenishing the solutions by the addition of components did not solve the problem.

It is the objective of this invention to improve methods for making printed circuit boards, involving fixing and electroless deposition steps, by extending the bath life of the fixing solution employed. With the process improvement disclosed and claimed herein, the fixing solution is operable for extended periods of use and impurities which contaminate such solutions are effectively removed. The level of effectiveness of the so-treated solution is monitored spectrophotometrically, thus allowing for recycling of treated fixing solutions.

In accordance with this invention, there is disclosed a method for making conductive metal patterns by treating a substrate with a solution comprising a reducible salt of a non-noble metal and a light radiation sensitive reducing compound selected from quinones, benzoquinones, anthraquinones and derivatives thereof, and anthraquinone disulfonic acids and salts thereof, exposing the treated substrate to light radiant energy to reduce the metal salt to form a real image, and immersing the substrate in an electroless metal deposition bath to deposit a conductive metal pattern on the real image, and further comprising the step of treating the exposed substrate prior to electrolessly depositing metal with a fixing solution comprising a complexing agent for the non-noble metal, characterized in that the concentration of the light radiation sensitive reducing compound built up in said fixing solution as the result of said treatment is substantially continuously monitored by spectrographic analysis, and that, by continuous carbon treatment, said compound is maintained at a concentration below 0,4 mmoles/l.

In a preferred embodiment, said compound is maintained at a concentration between 0,15 and 0,05 mmoles/l.

In a further embodiment, the carbon treatment is effected in a continuous manner wherein the treated fixing solution is recycled during processing.

2

EP 0 142 025 B1

In another embodiment, the carbon employed is regenerated by treatment with sulfuric acid or sodium persulfate.

In a further embodiment, a fixing solution is employed comprised of a complexing agent for the non-noble metal and a reducing agent, the latter selected from formaldehyde or ascorbic acid.

The process improvement disclosed herein pertains to the extension in bath life of fixing solutions. The improvement allows for the effective removal of impurities and contaminants thereby controlling the efficiency of the fixing bath. The level of activity of the bath is uniquely monitored spectrophotometrically.

The method improved herein relates to the manufacture of printed circuit boards involving, inter alia, an electroless deposition step.

In the first step of the method improved herein, a substrate is treated with a solution comprising a reducible salt of a non-noble metal and a light radiation sensitive reducing compound.

Among the materials which may be used as substrates are insulating thermosetting resins, thermoplastic resins, ceramics, and mixtures of the foregoing, including fiber, e.g., fiberglass impregnated embodiments of the foregoing.

In producing the real image, the metal species nuclei are reduced from their salt or a composition of the salt in situ in selected areas on the surface of the substrate by application of radiant energy, such as ultraviolet light and visible light, Z-rays, electron beams, and the like.

The reducible metal salt can comprise, in general, a cation selected from the metal of Group VIII and IB of the Periodic Table of Elements. The anion associated in such metal salts can vary widely and can comprise organic and inorganic anions such as halides, sulfates, nitrates, formates, gluconates, acetates, and the like. Some typical salts include cupric formate, cupric gluconate, cupric acetate, cupric chloride, cupric nitrate, nickel chloride, ferrous sulfate and cobalt chloride.

The radiant energy sensitive compound used in association with the reducible metal has a property of absorbing radiant energy and transferring it, thus exercising a reducing action on the exposed metal salt. Such radiant energy-sensitive compounds form a family of scope well known to those skilled in the art. Because visible and ultraviolet light are the most convenient sources of radiant energy, the solutions used in this invention preferably contain such compounds which are sensitive to visible or ultraviolet light. Particularly suitable compounds are anthraquinone-2,6-(and 2,7)disulfonic acid disodium salts.

After exposure to the radiant energy source, the real image is treated with a fixing solution comprising a suitable complexing or chelating agent for the metal ions remaining on the surface. For copper ions, such complexing or chelating agents include ethylenediaminetetraacetic acid (EDTA), ethylenedinitrilotetra-2-propanol (EDTP), triethanolamine, malic acid, maleic acid, citric acid, tartaric acid, etc.

The fixing solution may optionally also comprise a reducing agent for protecting the metal species sites forming said real image. Such reducing agents are well known in the art of electroless metal deposition. Where copper salts are used in the sensitizing solution of the subject invention, typical reducing agents include, under alkaline aqueous conditions (pH >7), formaldehyde and paraformaldehyde, and under acidic aqueous conditions (ph <7), ascorbic acid and hypophosphite species, e.g., sodium hypophosphite, potassium hypophosphite, etc. The reducing agent serves two purposes. As an antioxidant it prevents reoxidation of the metal nuclei comprising the real image. Autocatalytic ion reducing agents can also simultaneously reduce metal ions, e.g., $Cu^{+2}$, to its corresponding metal, e.g., $Cu^{\circ}$, on the metal nuclei of the real image, thus reinforcing the real image.

The surface containing the real image is created, e.g., by immersion, with the fixing solution for a period of time, e.g., typically 90 seconds, and at a temperature, e.g., typically 20° to 35°C.

The fixing solution serves to wash out or remove the unexposed (as well as unfixed) portions of the sensitizing layer. The sensitizing layer comprises both the radiant energy sensitive compound and the reducible metal. When the radiant energy sensitive compound, e.g., comprises an anthraquinone disulfonic acid, it must be completely removed prior to intensifying the formed image in an electroless copper deposition solution. Anthraquinone disulfonic acids become chemical reducing agents at the high pH of electroless copper solutions and cause copper deposits outside of the image area. The fixed real image surface can be directly treated with an electroless metal deposition solution without additional rinsing steps. The surface may, however, be rinsed with water or any other inert rinsing agent without fear of losing the real image. Suitable electroless metal deposition solutions are well known in the art and will not be elaborated herein. The electroless metal deposit may be built up to a desired thickness by prolonging exposure to the electroless metal deposition solution or, alternatively, may be further built up by being electroplated in a standard electroplating bath.

Due to the lack of a practicable analytical method to measure the actual effectiveness of fixing solutions, as employed above, the prior practice was to replace it whenever an undesirable result developed. The process improvement disclosed herein involves the use of a reliable and effective analytical technique to monitor the fixing bath solution as well as a treatment which controls the concentration of the radiant energy absorbing compound present in said solution at a selected level not to exceed 0,4 m moles/liter.

Such maintenance of the maximum concentration is effected by carbon treatment of the fixing solution as the concentration rises, with said concentration monitored by spectrographic analysis, e.g. with a double beam, UV spectrophotometer.

At about 325 nm, a spectral peak is detected for anthraquinone derivatives. The absorbance of this

3

EP 0 142 025 B1

peak increases with the square decimeters of substrates produced per liter of the fixing solution.

In order to control the level of radiation energy absorbing compounds, e.g., anthraquinone derivatives, at the selected level, the fixing solution is treated with carbon.

This treatment is preferentially effected by passing the fixing solution through a dense bed of activated granular carbon whereupon organic contaminants are absorbed and other particles trapped. Contaminant-free, clean and clear fixing solution is recycled back to the fixer tank. With such carbon treatment, the fixing bath can be operated at very low contamination levels and remains water white.

The carbon, after used as described above, can be regenerated by treatment with sulfuric acid or with persulfate. In the sulfuric acid method, 50% aqueous sulfuric acid is poured slowly into the carbon filter cartridge and allowed to sit for two hours. After removing the sulfuric acid and rinsing with water, the reactivated carbon can be reintroduced into the processing loop.

In the persulfate method, the carbon container is treated for 1 hour with sodium persulfate solution (120 g/l, pH < 3,5). After water rinsing, the carbon is reactivated.

Example 1

An acidic fixing solution is made by dissolving 20 g of maleic acid in 1 liter of water and adjusting the pH of the said solution to 5 with sodium hydroxide. The fixing solution thus prepared shows no peak but strong absorption in UV range lower than 310 nm. This UV broad absorption is compensated by placing such fresh fixing solution instead of deionized water in a reference cell of the spectrophotometer. With the thus prepared instrument, the addition of 0,084 g/l of 2,6-anthraquinone disulfonic acid disodium salt to the fixing solution to be measured, this compensation technique reveals a well-defined peak at 325 nm.

The introduction of 0,168 g/l 2,6-anthraquinone doubles the absorption peak at this wavelength. A treatment of the anthraquinone containing fixing solution by 60 g/l granular activated carbon (12 by 40 US mesh) effectively removes the anthraquinone salt with a 2-hour carbon treatment removing about 50% of the anthraquinone salt as shown in the following Table I:

TABLE I

| Amount of 2,6-Anthraquinone Disulfonic Acid Disodium Salt (m mole/liter) | Carbon Treatment (hour) | Absorbance at $\lambda = 325$ nm max. |
|---|---|---|
| 0,00 | None | 0,01 |
| 0,20 | None | 1,06 |
| 0,40 | None | 2,08 |
| 0,40 | 2 hours | 1,06 |
| 0,40 | 4 hours | 0,65 |
| 0,40 | 24 hours | 0,29 |

The addition of 2,7-anthraquinone disulfonic acid disodium salt to the maleic acid fixing solution following the same procedures as described above, also shows a well-defined absorption peak at 325 nm. The direct proportionality of the absorbance vs. concentration is also demonstrated in the following Table II. The anthraquinone salt is sufficiently removed by carbon treatment.

TABLE II

| Amount of 2,7-Anthraquinone Disulfonic Acid Disodium Salt (m mole/liter) | Carbon Treatment (hours) | Absorbance at $\lambda = 325$ nm max. |
|---|---|---|
| 0,2 | None | 0,89 |
| 0,4 | None | 1,90 |
| 0,4 | 2 hours | 0,84 |
| 0,4 | 4 hours | 0,43 |
| 0,4 | 24 hours | 0,16 |

4

## Example 2

Panels of glass cloth reinforced epoxy resin laminate sheets, NEMA Grade FR—4, provided with a phenolic resin-nitrile rubber adhesive coating were adhesion promoted by a 10 minute immersion in the following solution at 40°C;

| | |
|---|---|
| Chromium trioxide | 100 g/l |
| Sulfuric acid | 550 g/l |
| Sodium fluoride | 10 g/l, |

rinsed, immersed in a reducing soluble to reduce residual hexavalent chromium, and again rinsed.

The thus adhesion promoted panels were immersed for 10 min in the sensitizer solution of Example 31 of US patent 3,994,727, the excess sensitizer wiped from the surface with a synthetic elastomer sponge, and the coating on the panels dried for 3 minutes at 50°C. The sensitizer-coated panels were exposed for 1 minute through a negative mask to the UV radiation of a 2 KW Mercury vapor lamp thus forming the printed circuit image. After exposure, the image was fixed by immersion in the maleic acid fixing solution described above, and for a time varied between 2 minutes and 10 minutes. The panels were then rinsed for 3 minutes in running water, and placed in an electroless copper strike bath to form a stabilized conductive copper pattern approximately 2 μm thick. The electroless copper strike bath used was of the following composition:

| | | |
|---|---|---|
| Copper(II) salt | 0,05 | mole/l |
| Ethylenediaminetetra-2-propanol (EDTP) | 0,08 | mole/l |
| Formaldehyde | 0,05 | mole/l |
| Alkylphenoxyglycidolphosphate-ester | 0,0009 | mole/l |
| Sodium cyanide | 0,0002 | mole/l |
| 2-mercaptobenzothiazole | 0,0000003 | mole/l |
| Sulfide ion | 0,000005 | mole/l |
| Alkali metal hydroxide | to pH | 12,8 |
| Temperature | 52°C | |

After inspection, the panels were placed in a second electroless copper plating bath solution to deposit 35 μm of copper on the stabilized conductor image. The composition of the second electroless copper plating bath solution was:

| | | |
|---|---|---|
| Copper(II) salt | 0,04 | mole/l |
| Ethylenediaminetetra-2-propanol (EDTP) | 0,12 | mole/l |
| Formaldehyde | 0,05 | mole/l |
| Alkylphenoxyglycidolphosphate-ester | 0,0002 | mole/l |
| Sodium cyanide | 0,0005 | mole/l |
| 2-mercaptobenzothiazole | 0,0000003 | mole/l |
| Sulfide ion | 0,000005 | mole/l |
| Alkali metal hydroxide | to pH | 12,8 |
| Temperature | 52°C | |

After 0,03 m² of panel surface per liter were processed through the fixing solution, the plated-up panels showed some indiscriminate depositions of copper particles. The fixing solution was analyzed by the ultraviolet spectroscopy described hereinbefore and found to contain 0,12 m mol/l of anthraquinone

disulfonic acid. The fixing solution was circulated through a carbon packed filter until the anthraquinone disulfonic acid concentration was reduced to essentially zero. The fixing solution was then used to process additional panels which, after electroless plating, were found to be free of indistriminate copper deposits.

Example 3

An acid fixing solution, comprising 1% citric acid was prepared, showing a broad absorbance band ranging from 380 nm to 200 nm. The addition of 2,6-anthraquinone salt to the fixing solution shifts the band ranging from 340 nm to 200 nm. Using fresh fixing solution in the preference cell of the spectrophotometer to compensate for the UV band reveals the peak at 343 nm. This peak shows direct proportionality as shown in the following Table III:

TABLE III

| Amount of 2,6-Anthraquinone Disulfonic Acid Disodium Salt (m mole/liter) | Carbon Treatment (hours) | Absorbance at $\lambda = 343$ nm max. |
|---|---|---|
| 0,00 | None | 0,00 |
| 0,20 | None | 0,39 |
| 0,40 | None | 0,75 |
| 0,40 | 4 hours | 0,00 |

Carbon treating the anthraquinone comprising solution for 4 hours was found to completely remove the anthraquinone salt from the said solution.

Example 4

2,7-anthraquinone disulfonic acid disodium salt in acid fixing solution prepared as in Example 3 shows the same peak at 343 nm. The direct proportionality can be seen in the following Table IV:

TABLE IV

| Amount of 2,7-Anthraquinone Disulfonic Acid Disodium Salt (m mole/liter) | Carbon Treatment (hours) | Absorbance at $\lambda = 343$ nm max. |
|---|---|---|
| 0,00 | None | 0,00 |
| 0,20 | None | 0,33 |
| 0,40 | None | 0,66 |
| 0,40 | 4 hours | 0,00 |

Example 5

The procedure of Example 2 is repeated except that the maleic acid is replaced by citric acid with the fixing solution having the following formulation:

| | |
|---|---|
| Citric acid | 10 g/l |
| Ethylenedinitrotetra-2-propanol (EDTP) | 5 g/l |
| Cupric acetate | 2 g/l |
| Sodium hydroxide | to pH 6 |
| Ascorbic acid | 5 g/l |

Treating the panel after exposure to UV radiation darkens the formed image indicating that the fixing solution containing copper ions and ascorbic acid not only prevents formation of extraneous copper sites but reinforces the image, preventing image wash off in the fixing and subsequent processing steps.

When 0,06 m$^2$ of surface are passed through the fixed solution, extraneous copper sites are found on the panel surface after electroless copper plating. The fixing solution is analyzed spectrophotometrically and found to contain 0,12 m mol/l anthraquinone disulfonic acid. It is circulated through an activated carbon bed. When the spectrophotometric analysis shows the concentration to be reduced to 0,05 m mol/l anthraquinone disulfonic acid, the pH is readjusted to 6 and additional 0,06 m$^2$ of surface area are processed through the fixing solution before indiscriminate copper deposition is, again, observed.

Example 6

The addition of 2,6-anthraquinone salt to the 10% (by volume) to an acetic acid based fixing solution shows a peak at 325 nm if spectrophotometrically established as described hereinbefore. The absorbance at 325 nm is directly proportional to the concentration of the anthraquinone salt as shown in the following Table V. The efficiency of the removal of the salt by carbon treatment is also shown in the Table:

TABLE V

| Amount of 2,6-Anthraquinone Disulfonic Acid Disodium Salt (m mole/liter) | Carbon Treatment (hours) | Absorbance at $\lambda$ = 325 nm max. |
|---|---|---|
| 0,20 | None | 1,06 |
| 0,40 | None | 2,11 |
| 0,40 | 2 hours | 1,20 |
| 0,40 | 4 hours | 0,78 |
| 0,40 | 24 hours | 0,45 |

Example 7

A solution suitable for use as a fixing solution is prepared by adding 100 ml of 37% formaldehyde and 40 g of tetrasodium EDTA to enough water to make 1 liter and adjusting the pH to 12,5. The solution thus prepared shows no peak at 325 nm and its absorbance at 325 nm reads 0,01. An addition of 0,084 g/l of 2,6-anthraquinone disulfonic acid disodium salt to this fixing solution introduced a peak at 325 nm with an absorbance reading of 1,08. Double the concentration of 2,6-anthraquinone in the solution doubles the absorbance at the wave length of 325 nm as indicated in Table VI below. A treatment of the anthraquinone containing solution with 60 g/l granular activated carbon (12 by 40 US mesh) removes the anthraquinone salt as indicated by the absorption measurement at 325 nm in the following Table:

TABLE VI

| Amount of 2,6-Anthraquinone Disulfonic Acid Disodium Salt (m mole/liter) | Carbon Treatment (hours) | Absorbance at $\lambda$ = 325 nm max. |
|---|---|---|
| 0,00 | None | 0,01 |
| 0,20 | None | 1,08 |
| 0,40 | None | 2,15 |
| 0,40 | 2 hours | 0,73 |
| 0,40 | 4 hours | 0,50 |

A freshly made-up fixing solution of this Example without the addition of the anthraquinone salt is used as described in Example 2 for the production of printed circuit boards. Corresponding the surface area of panels processed, the fixing solution shows increasing absorbance at 325 nm indicating the increasing concentration of the anthraquinone salt present in it.

The solution was treated through a Sethco carbon filter cartridge after processing 0,01 to 0,02 m² panel surface per liter or a rusty-red coloration of the fixing solution appeared. Organic impurities were absorbed by the dense bed of activated, granular carbon. In addition, a double-layered polypropylene inner sleeve filter wrapped over an inert polypropylene mesh core was used to remove particles down to 10 μm size. The thus purified fixing solution was again used for processing panels and the purification procedure repeated whenever indicated to be necessary as described hereinbefore.

Instead of employing the surface area processed or the coloration visually observed as the indication for the anthraquinone salt present in the fixing solution to have reached inadmissibly high concentration, spectrophotometry may successfully be used for monitoring said concentration.

Following the procedure described in Examples 1 and 2, 2,7-anthraquinone present in the fixing solution is indicated by the appearance of a well-defined absorbance at 325 nm.

The following Table VII demonstrates the direct proportionality of absorbance vs. concentration. As also shown in the Table, sufficient removal of the anthraquinone salt is achieved by carbon treatment of the fixing solution.

TABLE VII

| Amount of 2,6-Anthraquinone Disulfonic Acid Disodium Salt (m mole/liter) | Carbon Treatment (hours) | Absorbance at $\lambda = 325$ nm max. |
|---|---|---|
| 0,00 | None | 0,01 |
| 0,20 | None | 0,96 |
| 0,40 | None | 1,86 |
| 0,40 | 2 hours | 0,81 |
| 0,40 | 4 hours | 0,53 |

## Claims

1. A method for making conductive metal patterns by treating a substrate with a solution comprising a reducible salt of a non-noble metal and a light radiation sensitive reducing compound selected from quinones, benzoquinones, anthraquinones and derivatives thereof, and anthraquinone disulfonic acids and salts thereof, exposing the treated substrate to light radiant energy to reduce the metal salt to form a real image, and immersing the substrate in an electroless metal deposition bath to deposit a conductive metal pattern on the real image, and further comprising the step of treating the exposed substrate prior to electrolessly depositing metal with a fixing solution comprising a complexing agent for the non-noble metal, characterized in that the concentration of the light radiation sensitive reducing compound built up in said fixing solution as the result of said treatment is substantially continuously monitored by spectrographic analysis, an that, by continuous carbon treatment, said compound is maintained at a concentration below 0,4 mmoles/l.

2. The method of claim 1, characterized in that said compound is maintained at a concentration between 0,15 and 0,05 mmoles/l.

3. The method of claim 1 and 2, characterized in that the complexing agent is selected from ethylenediaminetetraacetic acid (EDTA), ethylenedinitrilotetra-2-propanol (EDTO), malic acid, maleic acid, citric acid, tartaric acid and triethanolamine.

4. The method of claims 1 to 3, characterized in that said carbon is regenerated by treatment with sulfuric acid or sodium persulfate.

## Patentansprüche

1. Ein Verfahren zum Herstellen von leitfähigen metallischen Mustern durch Behandeln einer Trägerplatte mit einer Lösung, die ein reduzierbares Salz eines nichtedlen Metalles und ein lichtempfindlichen Reduktionsmittel, ausgewählt aus Chinonen, Benzochinonen, Anthrachinonen und deren Abkömmlingen und Anthrachinondisulfonsäuren und deren Salzen enthält, Aussetzen der so vorbehandelten Trägerplatte einer Strahlungsenergie zum Reduzieren des Metallsalzes und Ausbilden eines realen Abbildes, und Eintauchen der Trägerplatte in ein stromlos Metall abscheidendes Bad, um so · auf dem realen Abbild ein leitfähiges metallisches Muster auszubilden, und das weiterhin einen Verfahrensschritt enthält, bei dem vor dem stromlosen Metallisieren die Trägerplatte in eine Fixierungslösung gebracht wird, die einen Komplexer für das nichtedle Metall enthält, dadurch gekennzeichnet, daß die Konzentration des lichtempfindlichen Reduktionsmittels, die sich als Folge der genannten Behandlung

EP 0 142 025 B1

in der Fixierungslösung aufbaut, laufend durch spektrografische Analyse überwacht und durch fortwährende Behandlung mit Aktivkohle bei einer Konzentration von unter 0,4 mMol/l gehalten wird.

2. Das Verfahren nach Anspruch 1, dadurch gekennzeichnet, daß die Konzentration des lichtempfindlichen Reduktionsmittels auf einem Wert zwischen 0,15 und 0,05 mMol/l gehalten wird.

3. Das Verfahren nach den Ansprüchen 1 und 2, dadurch gekennzeichnet, daß der Komplexer ausgewählt ist aus Ethylendiamintetra-Essigsäure (EDTA), Ethylendinitrilotetra-2-propanol (EDTP), Apfelsäure, Maleinsäure, Zitronensäure, Weinsäure und Triethanolamin.

4. Das Verfahren nach den Ansprüchen 1 bis 3, dadurch gekennzeichnet, daß die Aktivkohle durch Behandeln mit Schwefelsäure oder Natriumpersulfat regeneriert wird.

**Revendications**

1. Une méthode de fabrication de modèles de métaux conducteurs par traitement d'un substrat avec une solution comprenant un sel réductible d'un métal non-noble et un composé réducteur sensible à des radiations lumineuses choisis parmi des quinones, benzoquinones, anthraquinones et leurs dérivés, et acides anthraquinonedisulfoniques et leurs sels, exposition du substrat ainsi traité à une énergie de rayonnement pour réduire le sel du métal avec formation d'une image réelle, puis immersion du substrat dans un bain de dépôt non-galvanique (dépôt chimique de métal) pour former un modèle de métal conducteur sur l'image réelle, avec en outre traitement du substrat exposé, avant le dépôt du métal par voie non-galvanique, avec une solution de fixage comprenant un agent pour complexer le métal non-noble, méthode caractérisée en ce que la concentration du composé réducteur sensible aux rayonnements lumineux qui s'accumule dans la solution de fixage à la suite de ce traitement est pratiquement contrôlée d'une manière continue par analyse spectrographique, et en ce que, par un traitement continu au carbone, la concentration de ce composé est maintenue au-dessous de 0,4 mmol par litre.

2. La méthode de la revendication 1, caractérisée en ce que le composé en question est maintenu à une concentration comprise entre 0,15 et 0,05 mmole par litre.

3. La méthode des revendications 1 et 2, caractérisée en ce que l'agent complexant est choisi parmi l'acide éthylènediamine-tétracétique (EDTA), l'éthylène-dinitrilo-tétra-2-propanol (EDTP), l'acide malique, l'acide maléique, l'acide citrique, l'acide tartrique et la triéthanolamine.

4. La méthode des revendications 1 à 3, caractérisée en ce que l'on régénère le carbone par un traitement avec de l'acide sulfurique ou du persulfate de sodium.